(19) Europäisches Patentamt
European Patent Office
Office européen des brevets

(11) **EP 4 707 767 A1**

(12) **EUROPEAN PATENT APPLICATION**

(43) Date of publication:
**11.03.2026 Bulletin 2026/11**

(21) Application number: **25198045.4**

(22) Date of filing: **26.08.2025**

(51) International Patent Classification (IPC):
$G01M\ 11/00^{(2006.01)}$    $G01R\ 29/08^{(2006.01)}$
$G01R\ 31/08^{(2020.01)}$    $G06F\ 17/14^{(2006.01)}$
$H04B\ 10/079^{(2013.01)}$

(52) Cooperative Patent Classification (CPC):
**H04B 10/0791; G01M 11/3145; G01R 29/0885;
G01R 31/08; G06F 17/148**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**GE KH LA MA MD TN**

(30) Priority: **27.08.2024 CN 202411188371**

(71) Applicant: **Siemens Aktiengesellschaft
80333 München (DE)**

(72) Inventors:
• **Wang, Qian
Chongqing, 400000 (CN)**
• **Zhao, Shu Yao
Nanjing, Jiangsu Province, 211100 (CN)**
• **Sun, Xuan
Nanjing, 211100 (CN)**

(74) Representative: **HKW Intellectual Property PartG
mbB
Theresienhöhe 12
80339 München (DE)**

(54) **OPTICAL FIBER BREAK DETECTION METHOD AND APPARATUS, RELAY PROTECTION APPARATUS, AND STORAGE MEDIUM**

(57) This application provides an optical fiber break detection method and apparatus, a relay protection apparatus, and a storage medium. The optical fiber break detection method includes: acquiring multiple current sampling data of a photodiode in an optical current transducer; respectively performing wavelet transform on the multiple current sampling data to obtain a detail coefficient corresponding to each of the current sampling data; and determining an on/off state of an optical fiber in the optical current transducer according to the detail coefficients corresponding to the multiple current sampling data. This solution can achieve the detection of an optical fiber break within relatively short time, thereby reducing the occurrence of malfunction in the relay protection apparatus in a case that the optical fiber break occurs.

FIG. 2

EP 4 707 767 A1

**Description**

TECHNICAL FIELD

This application relates to the field of optoelectronic technology, and in particular to, an optical fiber break detection method and apparatus, a relay protection apparatus, and a storage medium.

BACKGROUND

An Optical Current Transducer (OCT) is a device that measures current using optical principles. The OCT operates based on the Faraday magneto-optic effect, which means that an external magnetic field can deflect linearly polarized light propagating along the direction of the magnetic field in a medium. The deflection angle is proportional to both the magnetic field strength and consequently to the measured current magnitude. Therefore, the current can be determined indirectly by measuring this deflection angle. A break may occur in the optical fiber within the OCT. The current value measured after the optical fiber break occurs will suddenly increase, potentially triggering a malfunction in a relay protection apparatus using the OCT data. Therefore, optical fiber break detection needs to be performed on the OCT.

At present, optical fiber break detection is performed on the OCT based on a current sampling value of a photodiode (PD) in the OCT. It is determined that an optical fiber break occurs in the OCT when the current sampling value of the photodiode remains below a predetermined threshold for a period of time.

However, when the optical fiber break is determined based on the duration that the current sampling value of the photodiode remains below the predetermined threshold, the optical fiber break can be detected only long after their actual occurrence. During this period, the relay protection apparatus remains vulnerable to malfunction.

SUMMARY

In view of this, embodiments of this application provide an optical fiber break detection method and apparatus, an electronic device, and a storage medium, which can reduce the occurrence of malfunction of a relay protection apparatus when am optical fiber break occurs.

According to a first aspect, an embodiment of this application provides an optical fiber break detection method, including: acquiring multiple current sampling data of a photodiode in an optical current transducer; respectively performing wavelet transform on the multiple current sampling data to obtain a detail coefficient corresponding to each of the current sampling data; and determining an on/off state of an optical fiber in the optical current transducer according to the detail coefficients corresponding to the multiple current sampling data.

In a possible implementation, the acquiring multiple current sampling data of a photodiode in an optical current transducer includes: acquiring the multiple current sampling data of the photodiode continuously obtained by the optical current transducer; or selecting one current sampling datum at an interval of M current sampling data from the current sampling data of the photodiode continuously obtained by the optical current transducer according to a sampling order of the current sampling data to obtain multiple current sampling data that are selected, where M is an integer greater than or equal to 1.

In a possible implementation, the multiple current sampling data include N current sampling data, where N is an integer greater than 1, N is determined based on signal attenuation time and a sampling frequency corresponding to the multiple current sampling data, the signal attenuation time is equal to time required for a current signal outputted by the photodiode to attenuate to 0 after an optical fiber break occurs in the optical current transducer.

In a possible implementation, $N = f_s \cdot \Delta t$, where $f_s$ is used for representing the sampling frequency corresponding to the multiple current sampling data, and $\Delta t$ is used for representing the signal attenuation time.

In a possible implementation, the respectively performing wavelet transform on the multiple current sampling data to obtain a detail coefficient corresponding to each of the current sampling data includes: respectively performing wavelet transform on the multiple current sampling data through a Daubechies Wavelet function to obtain the detail coefficient corresponding to each of the current sampling data.

In a possible implementation, the determining an on/off state of an optical fiber in the optical current transducer according to the detail coefficients corresponding to the multiple current sampling data includes: determining positive detail coefficients corresponding to the multiple current sampling data as feature values, or determining absolute value of negative detail coefficients corresponding to the multiple current sampling data as feature values; and determining the on/off state of the optical fiber in the optical current transducer based on a change law of the sampling order of the corresponding current sampling data according to the multiple feature values.

In a possible implementation, the determining the on/off state of the optical fiber in the optical current transducer based on a change law of the sampling order of the corresponding current sampling data according to the multiple feature values includes: ordering the multiple feature values according to the sampling order of the corresponding current sampling data from front to back; determining a first quantity of adjacent feature value pairs that a subsequent feature value is greater than or equal to a preceding feature value in the ordered feature values; determining a second quantity of adjacent feature value pairs that a subsequent feature value is less than a preceding feature value in the ordered feature values; and determining that an optical fiber break occurs in the optical current transducer in a case that a difference between the first quantity and the second quantity is greater than or equal to a quantity threshold.

In a possible implementation, the quantity threshold is in a range of [0.3N, 0.5N), where N is used for representing the quantity of current sampling data included in the multiple current sampling data.

In a possible implementation, the method further includes: after determining that the optical fiber break occurs in the optical current transducer, setting an output value of the optical current transducer to an invalid state, and/or locking a relay protection apparatus that performs a protection action based on the output value of the optical current transducer.

According to a second aspect, an embodiment of this application provides an optical fiber break detection apparatus, including: an acquisition module, configured to acquire multiple current sampling data of a photodiode in an optical current transducer; a transform module, configured to respectively perform wavelet transform on the multiple current sampling data to obtain a detail coefficient corresponding to each of the current sampling data; and a detection module, configured to determine an on/off state of an optical fiber in the optical current transducer according to the detail coefficients corresponding to the multiple current sampling data.

In a possible implementation, the acquisition module is configured to acquire the multiple current sampling data of the photodiode continuously obtained by the optical current transducer; or select one current sampling datum at an interval of M current sampling data from the current sampling data of the photodiode continuously obtained by the optical current transducer according to a sampling order of the current sampling data to obtain multiple current sampling data that are selected, where M is an integer greater than or equal to 1.

In a possible implementation, the multiple current sampling data include N current sampling data, where N is an integer greater than 1, N is determined based on signal attenuation time and a sampling frequency corresponding to the multiple current sampling data, the signal attenuation time is equal to time required for a current signal outputted by the photodiode to attenuate to 0 after an optical fiber break occurs in the optical current transducer.

In a possible implementation, $N = f_s \cdot \Delta t$, where $f_s$ is used for representing the sampling frequency corresponding to the multiple current sampling data, and $\Delta t$ is used for representing the signal attenuation time.

In a possible implementation, the transform module is configured to respectively perform wavelet transform on the multiple current sampling data through a Daubechies Wavelet function to obtain the detail coefficient corresponding to each of the current sampling data.

In a possible implementation, the detection module includes: a selection submodule, configured to determine positive detail coefficients corresponding to the multiple current sampling data as feature values, or determine absolute value of negative detail coefficients corresponding to the multiple current sampling data as feature values; and a determination submodule, configured to determine the on/off state of the optical fiber in the optical current transducer based on a change law of the sampling order of the corresponding current sampling data according to the multiple feature values.

In a possible implementation, the determination submodule is configured to perform the following operations: ordering the multiple feature values according to the sampling order of the corresponding current sampling data from front to back; determining a first quantity of adjacent feature value pairs that a subsequent feature value is greater than or equal to a preceding feature value in the ordered feature values; determining a second quantity of adjacent feature value pairs that a subsequent feature value is less than a preceding feature value in the ordered feature values; and determining that an optical fiber break occurs in the optical current transducer in a case that a difference between the first quantity and the second quantity is greater than or equal to a quantity threshold.

In a possible implementation, the quantity threshold is in a range of [0.3N, 0.5N), where N is used for representing the quantity of current sampling data included in the multiple current sampling data.

In a possible implementation, the apparatus further includes: an execution module, configured to, after determining that the optical fiber break occurs in the optical current transducer by the detection module, set an output value of the optical current transducer to an invalid state, and/or block a relay protection apparatus that performs a protection action based on the output value of the optical current transducer.

According to a third aspect, an embodiment of this application provides a relay protection apparatus, including: at least one memory, configured to store instructions; and at least one processor, configured to perform the optical fiber break detection method described above based on the instructions stored in the memory.

According to a fourth aspect, an embodiment of this application provides a computer-readable storage medium, having computer instructions stored therein, where the computer instructions, when executed by a processor, cause the processor to perform the optical fiber break detection method according to the first aspect or any possible implementation of the first aspect.

According to a fifth aspect, an embodiment of this application provides a computer program product, tangibly stored in a computer-readable medium and including computer-executable instructions, where the computer-executable instructions, when executed, cause at least one processor to perform the optical fiber break detection method according to the first aspect or any possible implementation of the first aspect.

As can be seen from the above technical solution, after acquiring the multiple current sampling data of the photodiode in the optical current transducer, wavelet transform is performed on the current sampling data to obtain the corresponding detail coefficients. Since the change features of the detail coefficients corresponding to the current sampling data in cases that an optical fiber break does not occur and occurs in the optical current transducer are different, the on/off state of the optical fiber in the optical current transducer can be determined based on the detail coefficients. Since the detail coefficients can be quickly acquired by performing wavelet transform on the current sampling data, and the on/off state of the optical fiber can be quickly determined based on the detail coefficients, the optical fiber break can be detected within a short time, thereby reducing the occurrence of malfunction in the relay protection apparatus in a case that the optical fiber break occurs.

BRIEF DESCRIPTION OF THE DRAWINGS

FIG. 1 is a schematic diagram of an applied exemplary system according to an embodiment of this application.

FIG. 2 is a flowchart of an optical fiber break detection method according to an embodiment of this application.

FIG. 3 is a schematic diagram of detail coefficients according to an embodiment of this application.

FIG. 4 is a schematic diagram of detail coefficients according to another embodiment of this application.

FIG. 5 is a flowchart of an optical fiber on/off state determination method according to an embodiment of this application.

FIG. 6 is a flowchart of an optical fiber break determination method according to an embodiment of this application.

FIG. 7 is a schematic diagram of an optical fiber break detection result according to an embodiment of this application.

FIG. 8 is a schematic diagram of an optical fiber break detection apparatus according to an embodiment of this application.

FIG. 9 is a schematic diagram of an optical fiber break detection apparatus according to another embodiment of this application.

FIG. 10 is a schematic diagram of an optical fiber break detection apparatus according to still another embodiment of this application.

FIG. 11 is a schematic diagram of an electronic device according to an embodiment of this application.

| | Description of reference numerals: | | | | |
| --- | --- | --- | --- | --- | --- |
| 11: | optical glass | 12: | primary conductor | 13: | LED |
| 14: | photodiode | 15: | polarizer | 16: | analyzer |
| 17: | sampling unit | 18: | analog-to-digital conversion unit | 19: | signal processing unit |
| 200: | optical fiber break detection method | 201-203: | method steps | 500: | optical fiber on/off state determination method |
| 501 -504 | method steps | 600: | optical fiber break determination method | 601-609: | method steps |
| A: | sampling point where an optical fiber break is detected | 800: | optical fiber break detection apparatus | 801: | acquisition module |
| 802: | transform module | 803: | detection module | 804: | execution module |

(continued)

| 8031: | selection submodule | 8032: | determination submodule | 1100: | electronic device |
|---|---|---|---|---|---|
| 1102: | processor | 1104: | communication interface | 1106: | memory |
| 1108: | communication bus | 1110: | program | | |

DETAILED DESCRIPTION

In order to enable those skilled in the art to better under the technical solutions of the embodiments of this application, the following clearly and completely describes the technical solutions of the embodiments of this application with reference to the accompanying drawings in the embodiments of this application. Clearly, the described embodiments are merely some rather than all of the embodiments of this application. All other embodiments obtained by those skilled in the art based on the embodiments of this application shall fall within the scope of protection of the embodiments of this application.

The terms used in this application are for the purpose of describing specific embodiments only and are not intended to limit this application. The singular forms of "a" and "the" used in this application and the appended claims are intended to include the plural forms as well, unless the context clearly indicates otherwise. It should be further understood that the term "and/or" used herein indicates and includes any or all possible combinations of one or more associated listed items. The nouns and pronouns about people used herein are not limited to specific genders.

It should be understood that although the terms such as "first", "second", and "third" may be used in this application to describe various information, the information should not be limited to these terms. These terms are merely used to distinguish between information of the same type. For example, without departing from the scope of this application, first information may also be referred to as second information, and similarly, second information may also be referred to as first information. Depending on the context, for example, the word "if" used herein may be interpreted as "in a case that" or "when", or "in response to determination".

To make the objectives, technical solutions, and advantages of this application clearer, the following further describes the implementations of this application in detail with reference to the accompanying drawings.

Exemplary System

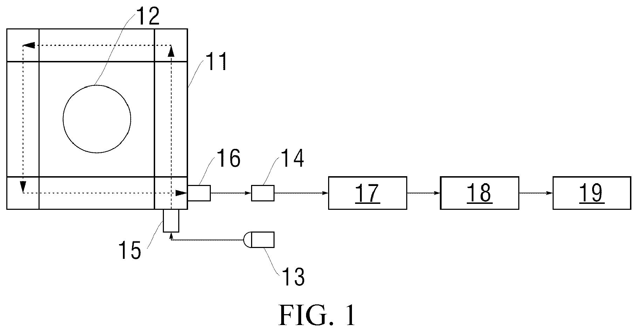

FIG. 1 shows an exemplary system applicable to an optical fiber break detection method according to an embodiment of this application. As shown in FIG. 1, the system includes optical glass 11, a primary conductor 12, an LED (light emitting diode) 13, a photodiode 14, a polarizer 15, an analyzer 16, a sampling unit 17, an analog-to-digital conversion unit 18, and a signal processing unit 19. The optical glass 11 is arranged around the primary conductor 12. A current transducer includes the optical glass 11, the polarizer 15, and the analyzer 16. A signal processing system is composed of the LED 13, the photodiode 14, the sampling unit 17, the analog-to-digital conversion unit 18, and the signal processing unit 19. The signal processing system is specifically located in a relay protection apparatus.

Light emitted by the LED 13 is transmitted through an optical fiber to the polarizer 15. The light is referred to as linearly polarized light after passing through the polarizer 15. After the light beam goes around the primary conductor 12 in the optical glass 11, the polarization plane of the light beam rotates based on the Faraday magneto-optic effect. The rotation angle is proportional to the integral of the magnetic field strength along a path of the polarized light through the optical glass. The linearly polarized light with the polarization plane rotated is transmitted through the optical fiber to the photodiode 14 after passing through the analyzer 16, and the photodiode 14 outputs a current with a corresponding magnitude based on the received light.

The sampling unit 17 samples the current outputted by the photodiode 14 according to a predetermined frequency to obtain a sampled current signal. The sampled current signal is an analog signal. After the sampling unit 17 transmits the sampled current signal to the analog-to-digital conversion unit 18, the analog-to-digital conversion unit 18 converts the sampled current signal into a current sampling datum. The current sampling datum is a digital signal. The analog-to-digital conversion unit 18 transmits the current sampling data to the signal processing unit 19. The signal processing unit 19 may calculate the current value of the current in the primary conductor 12 based on the current sampling data. In a case that the current value in the primary conductor 12 is too large, the signal processing unit 19 may trigger the action of the relay protection apparatus, so as to protect a load connected to the primary conductor 12 and avoid the damage to the load due to overcurrent.

In a case that the optical fiber connecting the LED 13 and the polarizer 15 or the optical fiber connecting the analyzer 16 and the photodiode 14 breaks, the sampling current signal of the photodiode 14 will quickly attenuate to 0. Since the time constant of a low-pass filter that acquires a direct-current bias signal of the photodiode 14 is large, the direct-current bias signal of the sampled current signal after passing through the low-pass filter will maintain a stable output within a short period of time. According to the Faraday rotation angle calculation formula $\alpha = 0.5 \cdot \mathrm{asin}\left(1 - \frac{E_{out}}{E_{DC}}\right)$ , the input light intensity $E_{out}$ of the photodiode 14 rapidly attenuates to 0, and the direct-current bias signal $E_{DC}$ of the sampled current signal maintains a stable output within a short period of time. The calculated Faraday rotation angle $\alpha$ will suddenly increase, and the current value of the current in the primary conductor 12 calculated based on the Faraday rotation angle will also suddenly increase, consequently causing the relay protection apparatus to malfunction.

Based on this, the inventor came up with the idea that the signal processing unit 19 may perform wavelet transform on the current sampling data to obtain detail coefficients corresponding to the current sampling data, then whether the optical fiber in the optical current transducer breaks can be quickly detected based on the detail coefficients corresponding to the multiple current sampling data, and in a case that the optical fiber break is detected, the calculated current value of the current in the primary conductor 12 is set to invalid, or the relay protection apparatus is locked, so that the relay protection apparatus executing the protection action will not malfunction due to the optical fiber break.

The embodiment of this application mainly focuses on a process of optical fiber break detection performed by the signal processing unit 19. The process of optical fiber break detection performed by the signal processing unit 19 will be described in detail in the following text.

## Optical Fiber Break Detection Method

Based on the above system, an embodiment of this application provides an optical fiber break detection method. The optical fiber break detection method may be performed by the signal processing unit 19 described above. Of course, an apparatus that performs the optical fiber break detection method may also be regarded as a relay protection apparatus. The optical fiber break detection method will be described below in detail through multiple embodiments.

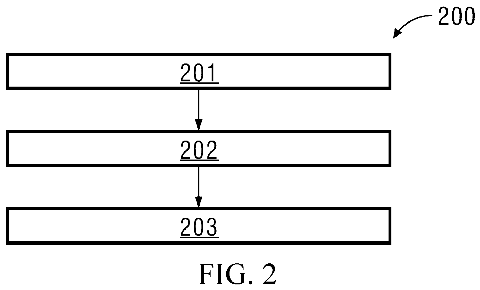

FIG. 2 is a flowchart of an optical fiber break detection method 200 according to an embodiment of this application. As shown in FIG. 2, the optical fiber break detection method 200 includes the following steps:

In step 201, multiple current sampling data of a photodiode in an optical current transducer are acquired.

As shown in FIG. 1, the sampling unit 17 in the optical current transducer samples the current outputted by the photodiode 14 according to a predetermined frequency to obtain a sampled current signal. After the sampled current signal is inputted into the analog-to-digital conversion unit 18, the analog-to-digital conversion unit 18 converts the sampled current signal into a sampled current datum.

In an example, the sampling unit 17 samples the current outputted by the photodiode 14 according to a sampling frequency of 16 kHz to obtain a sampled current signal each time. The analog-to-digital conversion unit 18 performs analog-to-digital conversion on each sampled current signal to obtain a corresponding current sampling datum.

In order to detect an optical fiber break in the optical current transducer in time, multiple current sampling data recently converted by the analog-to-digital conversion unit 18 may be acquired, or partial current sampling data recently converted by the analog-to-digital conversion unit 18 may be acquired, and then optical fiber break detection is performed based on the acquired multiple current sampling data.

The optical current transducer here may be specifically a magneto-optic glass type optical current transducer.

In step 202, wavelet transform is respectively performed on the multiple current sampling data to obtain a detail coefficient corresponding to each of the current sampling data.

After the multiple current sampling data for optical fiber break detection are acquired, wavelet transform is respectively performed on each of the current sampling data to obtain a detail coefficient corresponding to each of the current sampling data.

Wavelet transform is a mathematical tool used for analyzing frequency components of data such as signals or images. It provides a flexible way to observe local features of signals by decomposing them into time (or space)-frequency representations.

By performing wavelet transform on the current sampling data, detail coefficients, approximation coefficients, energy spectra of wavelet transform, power spectra of wavelet transform, phase information of wavelet transform, modal matrices of wavelet transform, reconstruction of wavelet transform, features of wavelet transform and the like may be obtained.

The detail coefficients represent the high-frequency parts of the signals at different scales. They capture local change and rapid change features in the data such as edges, textures, or noise.

The approximation coefficients represent the low-frequency parts of the signal, and usually correspond to the smoothed version or main structure of the signals.

Since the current sampling data undergoes rapid changes within a short period of time when an optical fiber break occurs, and the detail coefficients can capture the local change and rapid change features in the data, wavelet transform may be performed on the current sampling data to obtain the detail coefficients, thereby determining whether an optical fiber break occurs according to the detail coefficients.

In step 203, an on/off state of an optical fiber in the optical current transducer is determined based on the detail coefficients corresponding to the multiple current sampling data.

In cases that an optical fiber break does not occur and occurs in the optical current transducer, the change features of the detail coefficients corresponding to the current sampling data are different. According to the detail coefficients corresponding to the multiple current sampling data, the change features of the multiple detail coefficients can be determined, and the on/off state of the optical fiber in the optical current transducer can be determined, that is, whether an optical fiber break occurs in the optical current transducer can be determined, based on the change features of the detail coefficients.

In this embodiment of this application, after acquiring the multiple current sampling data of the photodiode in the optical current transducer, wavelet transform is performed on the current sampling data to obtain the corresponding detail coefficients. Since the change features of the detail coefficients corresponding to the current sampling data in cases that an optical fiber break does not occur and occurs in the optical current transducer are different, the on/off state of the optical fiber in the optical current transducer can be determined based on the detail coefficients. Since the detail coefficients can be quickly acquired by performing wavelet transform on the current sampling data, and the on/off state of the optical fiber can be quickly determined based on the detail coefficients, the optical fiber break can be detected within a short time, thereby reducing the occurrence of malfunction in the relay protection apparatus in a case that the optical fiber break occurs.

In a possible implementation, when the multiple current sampling data of the photodiode in the optical current transducer are acquired, multiple current sampling data continuously converted by the analog-to-digital conversion unit 18 may be acquired according to the sampling frequency of the sampling unit 17. Alternatively, some current sampling data may be selected from the multiple current sampling data continuously converted by the analog-to-digital conversion unit 18 according to a downsampling frequency for optical fiber break detection.

The sampling unit 17 will sample the output current of the photodiode 14 according to a high sampling frequency. The sampling unit 17 will transmit each sampled current signal obtained through sampling to the analog-to-digital conversion unit 18. The analog-to-digital conversion unit 18 will convert each received sampled current signal into current sampling data. Therefore, the frequency at which the analog-to-digital conversion unit 18 continuously obtains the current sampling data is equal to the sampling frequency of the sampling unit 17, that is, the optical current transducer continuously obtains the current sampling data of the photodiode 14 at the sampling frequency of the sampling unit 17.

In a case that the data processing capacity of the signal processing unit 19 is sufficient, multiple current sampling data recently converted by the analog-to-digital conversion unit 18, such as 40 current sampling data recently converted by the analog-to-digital conversion unit 18, may be acquired, and then the on/off state of the optical fiber in the optical current transducer is detected based on the multiple current sampling data recently converted by the analog-to-digital conversion unit 18.

In a case that the data processing capacity of the signal processing unit 19 is insufficient, one current sampling datum may be selected at an interval of M current sampling data from the current sampling data continuously obtained by the optical current transducer according to a sampling order of the current sampling data, and then the on/off state of the optical fiber in the optical current transducer is detected based on the multiple current sampling data that are selected, where M is an integer greater than or equal to 1.

Since the detection of the optical fiber break needs to be performed continuously and the sampling frequency of the sampling unit 17 is high, if the analog-to-digital conversion unit 18 performs optical fiber break detection once every time it converts one current sampling datum, in a case that the data processing capacity of the signal processing unit 19 is insufficient, this will result in an excessive data processing load of the signal processing unit 19, consequently influencing the normal operation of the signal processing unit 19. Therefore, one current sampling datum may be selected at an interval of M current sampling data from the current sampling data recently converted by the analog-to-digital conversion unit 18 according to a downsampling frequency lower than the sampling frequency of the sampling unit 17. In this way, after one new current sampling datum is selected each time, optical fiber break detection is performed once, thereby reducing the frequency of optical fiber break detection, and ensuring that the signal processing unit 19 can operate normally while ensuring that the occurrence of the optical fiber break can be rapidly detected.

It is to be understood that in a case that the data processing capacity of the signal processing unit 19 is insufficient, since one current sampling datum is selected at an interval of M current sampling data and optical fiber break detection is performed once after a new current sampling datum is selected each time, it is not that the analog-to-digital conversion unit 18 performs optical fiber break detection once after it converts one current sampling datum each time, but that the analog-to-digital conversion unit 18 performs optical fiber break detection once after every M+1 current sampling data are converted. Specifically, when one current sampling datum for optical fiber break detection is determined at an interval of M current sampling data, the analog-to-digital conversion unit performs optical fiber break detection once based on recently determined multiple current sampling data for optical fiber break detection after one new current sampling datum for optical fiber break detection is determined. Of course, the same window size may be retained, and a fixed quantity of current sampling data determined recently for optical fiber break detection are adopted to perform optical fiber break detection once after one new current sampling datum for optical fiber break detection is determined.

In an example, the sampling frequency of the sampling unit 17 is 16 kHz, and the downsampling frequency is 4 kHz. Therefore, from the 157 current sampling data recently converted by the analog-to-digital conversion unit 18, (4n-3)th current sampling data are selected according to an order of conversion, where n is in a range of $\{n \in Z | 0 < n \leq 40\}$, Z represents an integer set, that is, starting from the first current sampling datum, one current sampling datum is selected at an interval of three current sampling data, and then optical fiber break detection is performed according to the selected 40 current sampling data. After this optical fiber break detection, the analog-to-digital conversion unit 18 converts four current sampling data again for next optical fiber break detection, that is, next optical fiber break detection is performed according to (4m-3)th current sampling data of the 161 current sampling data, where m is in a range of $\{m \in Z | 1 < n \leq 41\}$, that is, the next optical fiber break detection is performed according to the selected 40 current sampling data, that is, optical fiber break detection is performed each time according to 40 current sampling data.

It is to be understood that in order to ensure the accuracy and timeliness of optical fiber break detection, the current sampling data for optical fiber break detection may be current sampling data recently converted by the analog-to-digital conversion unit 18 or selected from the current sampling data recently converted by the analog-to-digital conversion unit 18. For example, supposing that 40 current sampling data are required for optical fiber break detection, in a case that the data processing capacity of the signal processing unit 19 is sufficient, optical fiber break detection is performed according to the 40 current sampling data recently converted by the analog-to-digital conversion unit 18; in a case that the data processing capacity of the signal processing unit 19 is insufficient, one current sampling datum is selected at an interval of three current sampling data from 157 current sampling data recently converted by the analog-to-digital conversion unit 18, and optical fiber break detection is performed according to the selected 40 current sampling data. Among the 157 current sampling data recently converted by the analog-to-digital conversion unit 18, the acquisition time of the ith current sampling datum is earlier than the acquisition time of the (i+1)th current sampling datum, where i is a positive integer less than or equal to 157.

In this embodiment of this application, in a case that the data processing capacity of the signal processing unit 19 is sufficient, the multiple current sampling data continuously obtained by the optical current transducer may be acquired, and optical fiber break detection is performed based on the acquired current sampling data, so as to ensure that the optical fiber break can be detected in time. In a case that the data processing capacity of the signal processing unit 19 is insufficient, one current sampling datum may be selected at an interval of M current sampling data from the multiple current sampling data continuously obtained by the optical current transducer, and then optical fiber break detection is performed based on the selected multiple current sampling data, thereby ensuring that the signal processing unit 19 can operate normally while quickly detecting the optical fiber break.

In a possible implementation, the quantity N of the current sampling data for optical fiber break detection may influence the accuracy and timeliness of the optical fiber break detection result. In a case that N is small, it may lead to misjudgment of the optical fiber break. In a case that N is large, it takes a long time to detect the optical fiber break after the optical fiber break occurs. Therefore, N needs to be set to a proper value. For example, N may be determined based on the signal attenuation time and the sampling frequency of the current sampling data for optical fiber break detection, where the signal attenuation time is equal to time required for a current signal outputted by the photodiode to attenuate to 0 after the optical fiber break occurs in the optical current transducer.

The sampling frequency of the current sampling data for optical fiber break detection is the overall sampling frequency of the multiple current sampling data for optical fiber break detection. This sampling frequency may be different from the sampling frequency of the sampling unit 17. In a case that optical fiber break detection is performed based on the multiple current sampling data continuously converted by the analog-to-digital conversion unit 18, the sampling frequency of the current sampling data for optical fiber break detection is the same as the sampling frequency of the sampling unit 17. In a case that current sampling data are selected according to a downsampling frequency from the multiple current sampling data continuously converted by the analog-to-digital conversion unit 18 and optical fiber break detection is performed based on the selected current sampling data, the sampling frequency of the current sampling data for optical fiber break detection is the same as the downsampling frequency.

In this embodiment of this application, the changes of the detail coefficients corresponding to the current sampling signals within the signal attenuation time have a specific feature, so the current sampling signals that can be used for detecting the optical fiber break are within the signal attenuation time, while the sampling frequency of the current sampling data for optical fiber break detection determines the quantity of the current sampling data that can be collected for optical fiber break detection within the signal attenuation time. Therefore, the quantity of the current sampling data for optical fiber break detection is determined based on the signal attenuation time and the sampling frequency of the current sampling data for optical fiber break detection, thereby ensuring that the optical fiber break can be detected in time while ensuring the accuracy of the optical fiber break detection.

In a possible implementation, the quantity N of the current sampling data for optical fiber break detection may be calculated through formula $N = f_s \cdot \Delta t$, where $f_s$ is used for representing the sampling frequency of the current sampling data for optical fiber break detection, and $\Delta t$ is used for representing the signal attenuation time.

In an example, supposing that the downsampling frequency is 4 kHz and the signal attenuation time of the photodiode is 10 ms, then the quantity of the current sampling data for optical fiber break detection is N=4000 Hz×0.01 s=40.

In this embodiment of this application, since the current sampling data that can be used for determining the optical fiber break are within the signal attenuation time, in a case that the sampling frequency of the current sampling data for optical fiber break detection is fixed, the quantity of the current sampling data that can be acquired for optical fiber break detection is positively correlated with the signal attenuation time; in a case that the signal attenuation time is fixed, the quantity of the current sampling data that can be acquired for optical fiber break detection is positively correlated with the sampling frequency of the current sampling data for optical fiber break detection. Therefore, the quantity N of the current sampling data for optical fiber break detection can be calculated through formula $N = f_s \cdot \Delta t$, thereby ensuring the accuracy of optical fiber break detection while ensuring the timeliness of optical fiber break detection.

In a possible implementation, when wavelet transform is performed on the current sampling data, wavelet transform may be performed on the current sampling data through a Daubechies Wavelet function to obtain the detail coefficients corresponding to the current sampling data.

The Daubechies Wavelet function is a type of wavelet function widely applied to discrete wavelet transform, especially in fields such as signal analysis, data compression, and noise removal. The Daubechies Wavelet function is an orthogonal wavelet function, which can effectively separate the high-frequency and low-frequency parts from the signals due to its tight support characteristics and high vanishing moment.

In this embodiment of this application, since the detail coefficients represent the high-frequency parts of the signals at different scales, the approximation coefficients represent the low-frequency parts of the signals, and the Daubechies Wavelet function can effectively separate the high-frequency and low-frequency parts from the signals, performing wavelet transform on the current sampling data through the Daubechies Wavelet function can effectively separate the high-frequency and low-frequency parts of the current sampling data, and generate the detail coefficients based on the separated high-frequency parts, thereby ensuring the accuracy of the obtained detail coefficients.

In a possible implementation, when determining the on/off state of the optical fiber according to the detail coefficients, positive detail coefficients of the current sampling data may be determined as feature values, or absolute values of negative detail coefficients of the current sampling data may be determined as feature values, and then the on/off state of the optical fiber in the optical current transducer is determined based on a change law of the sampling order of the corresponding current sampling data according to each feature value.

Since the detail coefficients obtained after wavelet transform is performed on the current sampling data have symmetry, after the detail coefficients are obtained through wavelet transform on the multiple current sampling data for optical fiber break detection, positive detail coefficients may be selected as feature values, or absolute values of negative detail coefficients may be selected as feature values.

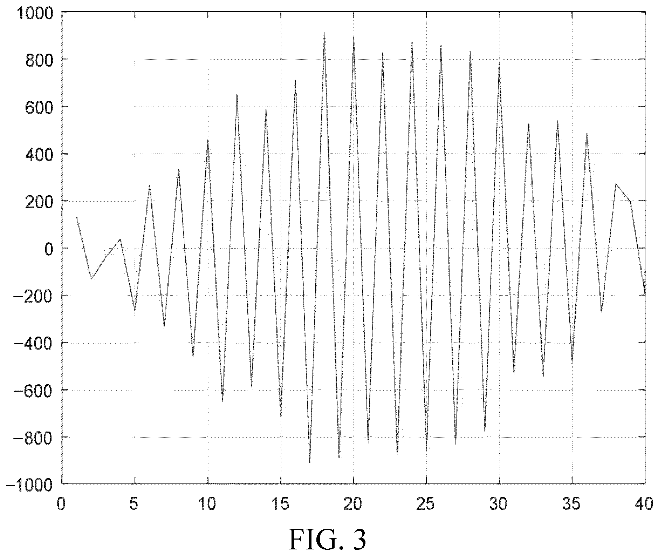

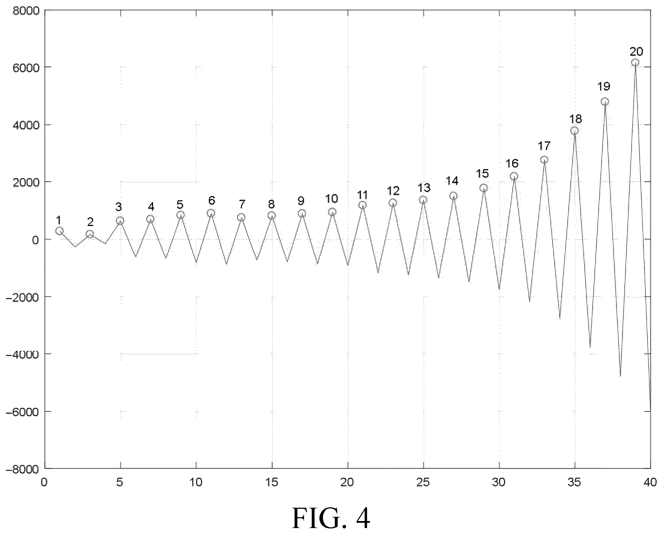

FIG. 3 and FIG. 4 each show a schematic diagram of detail coefficients according to an embodiment of this application. As shown in FIG. 3 and FIG. 4, the horizontal coordinates represent 40 sequentially sampled current sampling data, and the vertical coordinates represent the detail coefficients obtained through wavelet transform on the current sampling data. According to the sampling order, the detail coefficients corresponding to odd-numbered current sampling data are positive, and the detail coefficients corresponding to even-numbered current sampling data are negative. For example, the detail coefficients corresponding to the 1st, 3rd, and 5th current sampling data are positive, and the detail coefficients corresponding to the 2nd, 4th, and 6th current sampling data are negative.

It is to be understood that the sampling order described in this embodiment of this application refers to the sampling order of the current sampling data for optical fiber break detection. Since the current sampling data for optical fiber break detection may not be continuously converted by the analog-to-digital conversion unit 18, the current sampling data adjacent to each other in the sampling order for optical fiber break detection may not be the current sampling data continuously converted by the analog-to-digital conversion unit 18.

FIG. 3 shows a change law of the detail coefficient when an optical fiber break does not occur in the optical current transducer. FIG. 4 shows a change law of the detail coefficient when an optical fiber break occurs in the optical current transducer. It can be seen that the change laws of the detail coefficient in cases that an optical fiber break occurs and does not occur in the optical current transducer are different. Therefore, whether an optical fiber break occurs in the optical current transducer may be determined based on the change law of the sampling order of the corresponding current sampling data according to the detail coefficients.

In this embodiment of this application, according to the order that the corresponding current sampling data are sampled, the change law of each detail coefficient matches the on/off state of the optical fiber in the optical current transducer. The change laws of the detail coefficients are different in cases that an optical fiber break occurs and does not occur. Therefore, the on/off state of the optical fiber can be determined based on the change law of the detail coefficients. Since the detail coefficients obtained through wavelet transform on the current sampling data have symmetry, positive detail coefficients and negative detail coefficients may separately indicate the change law of the detail coefficient.

Therefore, the positive detail coefficients or the absolute values of the negative detail coefficients may be used as feature values, and then the on/off state of the optical fiber is determined based on the change law of the feature values, thereby reducing the quantity of data points used for determining the on/off state of the optical fiber, and improving the detection efficiency of the on/off state of the optical fiber.

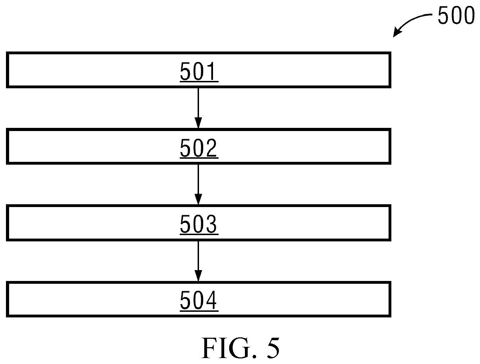

In a possible implementation, FIG. 5 shows a flowchart of an optical fiber on/off state determination method 500 according to an embodiment of this application. As shown in FIG. 5, the optical fiber on/off state determination method 500 includes the following steps:

In step 501, the multiple feature values are ordered according to the sampling order of the corresponding current sampling data from front to back.

After the multiple feature values are acquired, all feature values are ordered according to the sampling order of the current sampling data corresponding to the feature values, so that the feature values corresponding to the current sampling data sampled earlier are located before the feature values corresponding to the current sampling data sampled later.

In step 502, a first quantity of adjacent feature value pairs that a subsequent feature value is greater than or equal to a preceding feature value in the ordered feature values is determined.

After all feature values are ordered, the magnitudes of a preceding feature value and a subsequent feature value included in adjacent feature value pairs are compared, and the quantity of adjacent feature value pairs that a subsequent feature value is greater than or equal to a preceding feature value is statistically collected as the first quantity.

In an example, after 20 feature values are ordered, there are a total of 19 adjacent feature value pairs. In a case that 15 adjacent feature value pairs satisfy the condition that a subsequent feature value included is greater than or equal to a preceding feature value, then the first quantity is 15.

In step 503, a second quantity of adjacent feature value pairs that a subsequent feature value is less than a preceding feature value in the ordered feature values is determined.

After all feature values are ordered, the magnitudes of a preceding feature value and a subsequent feature value included in adjacent feature value pairs are compared, and the quantity of adjacent feature value pairs that a subsequent feature value is less than a preceding feature value is statistically collected as the second quantity.

In an example, after 20 feature values are ordered, there are a total of 19 adjacent feature value pairs. In a case that four adjacent feature value pairs satisfy the condition that a subsequent feature value included is less than a preceding feature value, then the first quantity is 4.

It is to be understood that step 502 and step 503 may be performed synchronously.

In step 504, in a case that a difference between the first quantity and the second quantity is greater than or equal to a quantity threshold, it is determined that an optical fiber break occurs in the optical current transducer.

After the first quantity and the second quantity are obtained, a difference between the first quantity and the second quantity may be calculated. In a case that the difference between the first quantity and the second quantity is greater than or equal to a preset quantity threshold, it may be determined that an optical fiber break occurs in the optical current transducer. In a case that the difference between the first quantity and the second quantity is less than the quantity threshold, it may be determined that an optical fiber break does not occur in the optical current transducer.

Based on the change law of the detail coefficients shown in FIG. 4, in a case that an optical fiber break occurs in the optical current transducer, the absolute values of the detail coefficients gradually increase according to the sampling order of the corresponding current sampling data, that is, a subsequent feature value of each adjacent feature value pair is greater than or equal to a preceding feature value. Due to sampling errors and wavelet transform errors, there may be certain errors in the detail coefficients. Therefore, the first quantity and the second quantity may be statistically collected, and a difference between the first quantity and the second quantity may be calculated. The difference between the first quantity and the second quantity can reflect the overall change law of the detail coefficients, and then the on/off state of the optical fiber is determined based on the difference between the first quantity and the second quantity, thereby ensuring the accuracy of the optical fiber on/off state detection result.

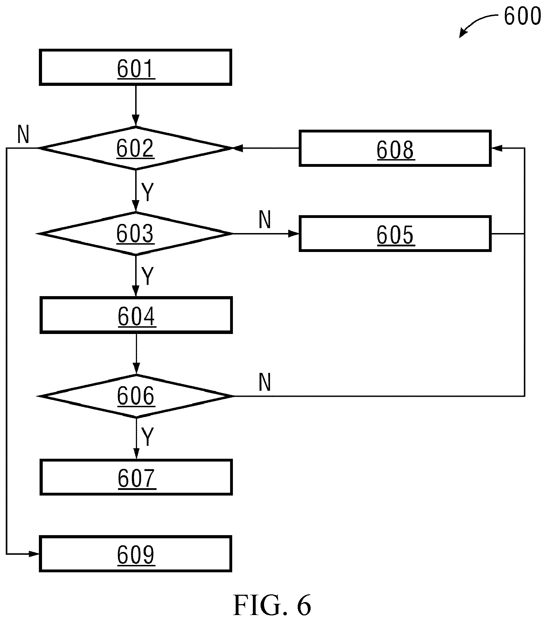

In an example, the calculation of the difference between the first quantity and the second quantity may be achieved through a counter. Taking the calculation of the difference between the first quantity and the second quantity through a counter as an example, the optical fiber on/off state determination method will be described. FIG. 6 shows an optical fiber break determination method 600. The optical fiber break determination method 600 includes the following steps:

In step 601, initialization=1 is performed.

In step 602, whether k is less than N is determined; in a case that a determination result is Yes, the process proceeds to step 603; and in a case that the determination result is No, the process proceeds to step 609.

N is the quantity of feature values.

In step 603, whether a $(k+1)^{th}$ feature value is greater than or equal to a $k^{th}$ feature value; in a case that a determination result is Yes, the process proceeds to step 604; and in a case that the determination result is No, the process proceeds to step 605.

According to the order of the ordered feature values, the $(k+1)^{th}$ feature value is a subsequent feature value in an adjacent feature value pair, and the $k^{th}$ feature value is a preceding feature value in the adjacent feature value pair.

In step 604, after the count value of the counter is added by 1, the process proceeds to step 606.

The initial value of the counter is 0.

In step 605, after the count value of the counter is subtracted by 1, the process precedes to step 608.

In step 606, whether the count value of the counter is greater than or equal to the quantity threshold is determined; in a case that a determination result is Yes, the process proceeds to step 607; and in a case that the determination result is No, the process proceeds to step 608.

In step 607, it is determined that an optical fiber break occurs in the optical current transducer, and the current process ends.

In step 608, after k=k+1 is executed, the process precedes to step 602.

In step 609, it is determined that an optical fiber break does not occur in the optical current transducer.

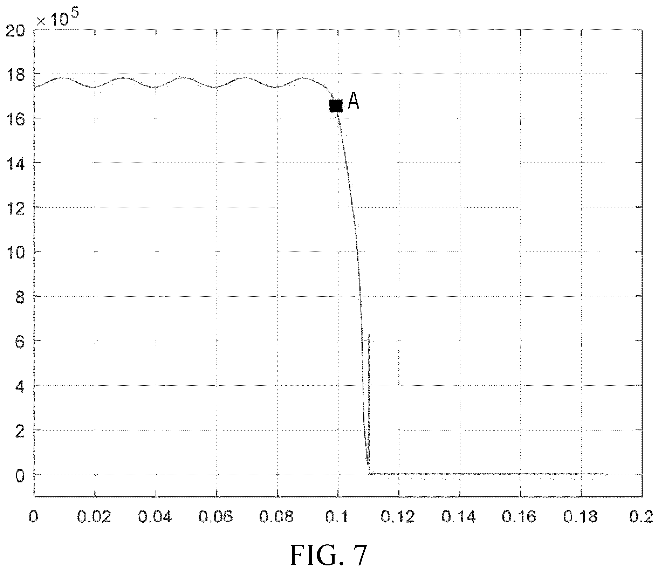

FIG. 7 shows a schematic diagram of an optical fiber break detection result according to an embodiment of this application. The optical fiber break detection result is obtained through the optical fiber break detection method according to any embodiment described above. As shown in FIG. 7, the horizontal coordinates represent time in seconds, the vertical coordinates represent the current sampling data in digital quantity, and point A is a sampling point where an optical fiber break is detected. It can be seen from FIG. 7 that after the optical fiber break occurs, the optical fiber break can be detected within a short period of time (such as less than 5 ms) after the detection current of the optical current transducer starts to decrease. Therefore, through the optical fiber break detection method provided in this embodiment of this application, the detection time of the optical fiber break can be shortened and the timeliness of optical fiber break detection can be improved.

In this embodiment of this application, in a case that an optical fiber break occurs in the optical current transducer, the absolute values of the detail coefficients gradually increase according to the sampling order of the corresponding current sampling data. For the absolute values of the detail coefficients with the feature values being positive or the detail coefficients with the feature values being negative, a subsequent feature value of each adjacent feature value pair is greater than or equal to a preceding feature value in a case that an optical fiber break occurs. Since there are errors in the feature values, a first quantity of adjacent feature value pairs that a subsequent feature value is greater than or equal to a preceding feature value and a second quantity of adjacent feature value pairs that a subsequent feature value is less than a preceding feature value are statistically collected, and a difference between the first quantity and the second quantity is calculated, so that the difference between the first quantity and the second quantity can reflect the overall change law of the detail coefficients, and the on/off state of the optical fiber can be determined based on the difference between the first quantity and the second quantity. This method is not only efficient, but also can ensure the accuracy of the optical fiber on/off state detection result.

In a possible implementation, the quantity threshold is in a range of [0.3N, 0.5N), where N represents the quantity of current sampling data for optical fiber break detection.

In an example, the quantity threshold may be 0.3N, 0.375N, 0.4N, 0.45N, and the like.

In this embodiment of this application, due to the errors in the current sampling data collected by the sampling unit 17 and the errors in obtaining the detail coefficients through wavelet transform on the current sampling data, there are some adjacent feature value pairs that a subsequent feature value is less than a preceding feature value in a case that an optical fiber break occurs. Therefore, a difference between the first quantity and the second quantity is calculated. The difference between the first quantity and the second quantity can reflect the overall change law of the detail coefficients. The difference between the first quantity and the second quantity is compared with the quantity threshold to determine the on/off state of the optical fiber. Determining the quantity threshold within the range of [0.3N, 0.5N) can reduce the probability of missed optical fiber break detection and the probability of false optical fiber break detection, thereby ensuring the accuracy of the optical fiber break detection result.

In a possible implementation, after determining that the optical fiber break occurs in the optical current transducer, an output value of the optical current transducer may be set to an invalid state, or a relay protection apparatus that performs a protection action may be locked based on the output value of the optical current transducer.

In this embodiment of this application, the output value of the optical current transducer is the current value of the primary conductor. After it is detected that the optical fiber break occurs in the optical current transducer, the output value of the optical current transducer is set to an invalid state, so that a device that performs an action based on the output value of the optical current transducer will not malfunction. The relay protection apparatus is locked, so that the relay protection apparatus will not act, thereby preventing the relay protection apparatus from malfunctioning due to the optical fiber break, and ensuring that the optical fiber break will not cause system operation interruption.

Optical Fiber Break Detection Apparatus

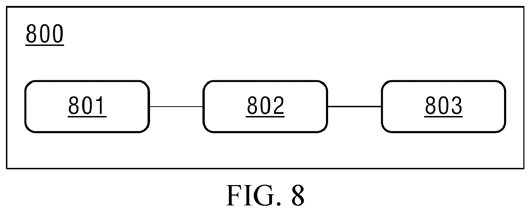

FIG. 8 shows a schematic diagram of an optical fiber break detection apparatus 800 according to an embodiment of this application. The optical fiber break detection apparatus 800 may be specifically integrated into the relay protection apparatus, or may be the relay protection apparatus itself. As shown in FIG. 8, the optical fiber break detection apparatus 800 includes:

an acquisition module 801, configured to acquire multiple current sampling data of a photodiode in an optical current transducer;

a transform module 802, configured to respectively perform wavelet transform on the multiple current sampling data to obtain a detail coefficient corresponding to each of the current sampling data; and

a detection module 803, configured to determine an on/off state of an optical fiber in the optical current transducer according to the detail coefficients corresponding to the multiple current sampling data.

In this embodiment of this application, after the acquisition module 801 acquires the multiple current sampling data of the photodiode in the optical current transducer, the transform module 802 performs wavelet transform on the current sampling data to obtain the corresponding detail coefficients. Since the change features of the detail coefficients corresponding to the current sampling data in cases that an optical fiber break does not occur and occurs in the optical current transducer are different, the detection module 803 may determine the on/off state of the optical fiber in the optical current transducer according to the detail coefficients. Since the detail coefficients can be quickly acquired by performing wavelet transform on the current sampling data, and the on/off state of the optical fiber can be quickly determined based on the detail coefficients, the optical fiber break can be detected within a short time, thereby reducing the occurrence of malfunction in the relay protection apparatus in a case that the optical fiber break occurs.

In a possible implementation, the acquisition module 801 is configured to acquire the multiple current sampling data of the photodiode continuously obtained by the optical current transducer; or select one current sampling datum at an interval of M current sampling data from the current sampling data of the photodiode continuously obtained by the optical current transducer according to a sampling order of the current sampling data to obtain multiple current sampling data that are selected, where M is an integer greater than or equal to 1.

In a possible implementation, the multiple current sampling data include N current sampling data, where N is an integer greater than 1, N is determined based on signal attenuation time and a sampling frequency corresponding to the multiple current sampling data, the signal attenuation time is equal to time required for a current signal outputted by the photodiode to attenuate to 0 after an optical fiber break occurs in the optical current transducer.

In a possible implementation, $N = f_s \cdot \Delta t$, where $f_s$ is used for representing the sampling frequency corresponding to the multiple current sampling data, and $\Delta t$ is used for representing the signal attenuation time.

In a possible implementation, the transform module 802 is configured to respectively perform wavelet transform on the multiple current sampling data through a Daubechies Wavelet function to obtain the detail coefficient corresponding to each of the current sampling data.

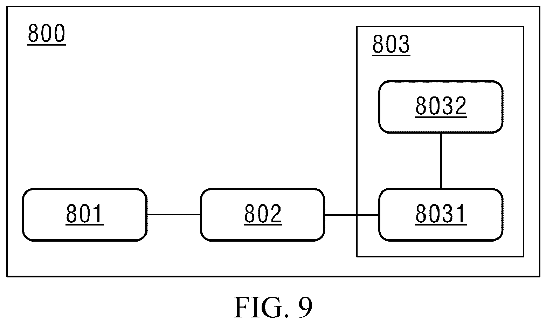

In a possible implementation, in the optical fiber break detection apparatus 800 shown in FIG. 9, the detection module 803 includes a selection submodule 8031 and a determination submodule 8032. The selection submodule 8031 is configured to determine positive detail coefficients corresponding to the multiple current sampling data as feature values, or determine absolute value of negative detail coefficients corresponding to the multiple current sampling data as feature values. The determination submodule 8032 is configured to determine the on/off state of the optical fiber in the optical current transducer based on a change law of the sampling order of the corresponding current sampling data according to the multiple feature values.

In a possible implementation, the determination submodule 8032 is configured to perform the following operations: ordering the multiple feature values according to the sampling order of the corresponding current sampling data from front to back; determining a first quantity of adjacent feature value pairs that a subsequent feature value is greater than or equal to a preceding feature value in the ordered feature values; determining a second quantity of adjacent feature value pairs that a subsequent feature value is less than a preceding feature value in the ordered feature values; and determining that an optical fiber break occurs in the optical current transducer in a case that a difference between the first quantity and the second quantity is greater than or equal to a quantity threshold.

In a possible implementation, the quantity threshold is in a range of [0.3N, 0.5N), where N is used for representing the quantity of current sampling data included in the multiple current sampling data.

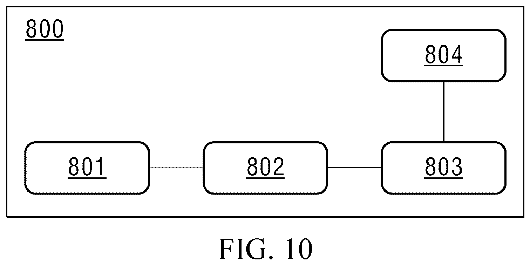

In a possible implementation, in the optical fiber break detection apparatus 800 shown in FIG. 10, the optical fiber break detection apparatus 800 further includes an execution module 804. The execution module 804 is configured to, after determining that the optical fiber break occurs in the optical current transducer by the detection module, set an output value of the optical current transducer to an invalid state, and/or block a relay protection apparatus that performs a protection action based on the output value of the optical current transducer.

It is to be understood that since the information exchange between and the execution processes of the modules and submodules in the optical fiber break detection apparatus 800 described above are based on the same concept as the method embodiment described above, for details, a reference may be made to the description in the method embodiment described above, which will not be repeated here.

## Relay Protection Apparatus

An embodiment of this application further provides a relay protection apparatus, which includes at least memory and at least one processor. The memory is configured to store instructions. The processor is configured to perform the optical fiber break detection method in any embodiment described above based on the instructions stored in the memory.

## Electronic Device

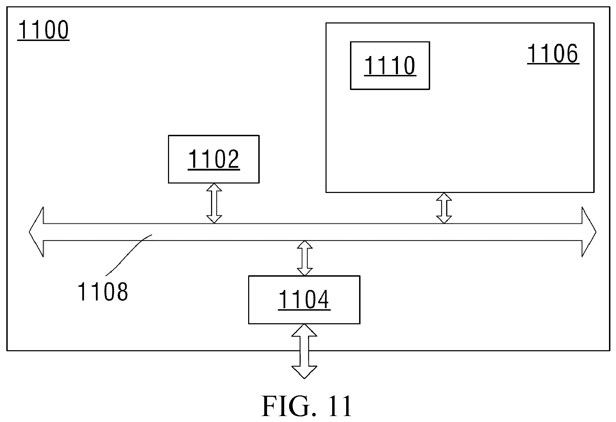

FIG. 11 shows a schematic diagram of an electronic device 1100 according to an embodiment of this application. The specific embodiment of this application does not limit the specific implementation of the electronic device. As shown in FIG. 11, the electronic device 1100 may include a processor 1102, a communication interface 1104, a memory 1106, and a communication bus 1108. The processor 1102, the communication interface 1104, and the memory 1106 communicate with one another through the communication bus 1108.

The communication interface 1104 is configured to communicate with other electronic devices or servers.

The processor 1102 is configured to execute a program 1110, and may specifically perform the relevant steps in any optical fiber break detection method embodiment described above.

Specifically, the program 1110 may include a program code, and the program code includes computer operation instructions.

The processor 1102 may be a CPU, an Application Specific Integrated Circuit (ASIC), or one or more integrated circuits configured to implement the embodiments of the present disclosure. One or more processors included in a smart device may be processors of the same type, such as one or more CPUs, or may also be processors of different types, such as one or more CPUs and one or more ASICs.

The memory 1106 is configured to store the program 1110. The memory 1106 may include a high-speed RAM, or may further include a non-volatile memory, for example, at least one magnetic disk storage.

The program 1110 may be specifically configured to cause the processor 1102 to perform the optical fiber break detection method in any embodiment described above.

For the specific implementation of each step in the program 1110, a reference may be made to the description of the corresponding step and unit in any optical fiber break detection method embodiment described above, which will not be repeated here. Those skilled in the art can clearly understand that for convenience and conciseness of description, for specific working processes of the devices and modules described above, a reference may be made to the description of the corresponding processes in the method embodiments described above, which will not be repeated here.

Through the electronic device in this embodiment of this application, after acquiring the multiple current sampling data of the photodiode in the optical current transducer, wavelet transform is performed on the current sampling data to obtain the corresponding detail coefficients. Since the change features of the detail coefficients corresponding to the current sampling data in cases that an optical fiber break does not occur and occurs in the optical current transducer are different, the on/off state of the optical fiber in the optical current transducer can be determined based on the detail coefficients. Since the detail coefficients can be quickly acquired by performing wavelet transform on the current sampling data, and the on/off state of the optical fiber can be quickly determined based on the detail coefficients, the optical fiber break can be detected within a short time, thereby reducing the occurrence of malfunction in the relay protection apparatus in a case that the optical fiber break occurs.

## Computer-readable Storage Medium

The present disclosure further provides a computer-readable storage medium, which stores instructions used for causing a machine to perform the optical fiber break detection method as described herein. Specifically, a system or an apparatus with a storage medium may be provided. A software program code implementing the functions of any embodiment described above is stored in the storage medium. A computer (or CPU or MPU) of the system or apparatus can read and execute the program code stored in the storage medium.

In this case, the program code read from the storage medium can implement the functions in any embodiment described above, and therefore the program code and the storage medium for storing the program code constitute a part of the present disclosure.

Examples of the storage medium for providing the program code include a floppy disk, a hard disk, a magneto-optical disk, an optical disk (for example, a CD-ROM, a CD-R, a CD-RW, a DVD-ROM, a DVD-RAM, a DVD-RW, or a DVD+RW), a magnetic tape, a non-volatile storage card, and an ROM. Optionally, the program code may be downloaded from a server computer through a communication network.

Computer Program Product

An embodiment of this disclosure further provides a computer program product, which includes computer instructions that instruct a computing device to perform operations corresponding to any of the multiple method embodiments described above.

It should be pointed out that according to the implementation needs, the various components/steps described in the embodiments of the present disclosure may be divided into more components/steps, or two or more components/steps or partial operations of components/steps may be combined to form a new component/step, so as to achieve the objectives of the embodiments of the present disclosure.

It is to be understood that the relational terms herein such as first and second are used only to distinguish an entity or operation from another entity or operation, and do not require or imply any actual relationship or sequence between these entities or operations. Moreover, the terms "include", "comprise" and any variation thereof are intended to cover a non-exclusive inclusion. Therefore, in the context of a process, a method, an object, or a device that includes a series of elements, the process, method, object, or device not only includes such elements, but also includes other elements not specified expressly, or may include inherent elements of the process, method, object, or device. If no more limitations are made, an element defined by "include a/an..." does not exclude other same elements existing in the process, the method, the article, or the device which includes the element.

Not all steps and modules in the processes and the diagrams of the system structures are necessary, and some steps or modules may be omitted according to the actual need. The execution sequence of the steps is not fixed and may be adjusted according to the need. The system structures described in the embodiments described above may be physical structures or logic structures. That is, some modules may be implemented by the same physical entity, or some modules may be implemented by multiple physical entities, or may be implemented by some components in multiple independent devices together.

In each embodiment described above, the hardware modules may be implemented mechanically or electrically. For example, a hardware module may include a permanent dedicated circuit or logic (for example, a dedicated processor, FPGA or ASIC) to complete a corresponding operation. The hardware module may further include a programmable logic or circuit (for example, a general-purpose processor or any other programmable processor), which may be temporarily set by software to complete a corresponding operation. The specific implementation (mechanical means, dedicated permanent circuit, or temporarily set circuit) may be determined based on the cost and time considerations.

This application has been described above in detail through the accompanying drawings and preferred embodiments. However, this application is not limited to these disclosed embodiments. Those skilled in the art can understand that the code review methods in the above different embodiments may be combined to obtain more embodiments of this application, which, however, also fall within the scope of protection of this application.

**Claims**

1. An optical fiber break detection method (100), comprising:

   acquiring a plurality of current sampling data of a photodiode (14) in an optical current transducer;
   respectively performing wavelet transform on the plurality of current sampling data to obtain a detail coefficient corresponding to each of the current sampling data; and
   determining an on/off state of an optical fiber in the optical current transducer according to the detail coefficients corresponding to the plurality of current sampling data.

2. The method according to claim 1, wherein the acquiring a plurality of current sampling data of a photodiode (14) in an optical current transducer comprises:

   acquiring the plurality of current sampling data of the photodiode (14) continuously obtained by the optical current transducer; or
   selecting one current sampling datum at an interval of M current sampling data from the current sampling data of the photodiode (14) continuously obtained by the optical current transducer according to a sampling order of the current sampling data, so as to obtain the selected plurality of current sampling data, where M is an integer greater than or equal to 1.

3. The method according to claim 1, wherein the plurality of current sampling data comprise N current sampling data, where N is an integer greater than 1, N is determined based on signal attenuation time and a sampling frequency corresponding to the plurality of current sampling data, the signal attenuation time is equal to time required for a current signal outputted by the photodiode (14) to attenuate to 0 after an optical fiber break occurs in the optical current transducer.

4. The method according to claim 3, wherein $N = f_s \cdot \Delta t$, $f_s$ is used for representing the sampling frequency corresponding to the plurality of current sampling data, and $\Delta t$ is used for representing the signal attenuation time.

5. The method according to claim 1, wherein the respectively performing wavelet transform on the plurality of current sampling data to obtain a detail coefficient corresponding to each of the current sampling data comprises:
respectively performing wavelet transform on the plurality of current sampling data through a Daubechies Wavelet function to obtain the detail coefficient corresponding to each of the current sampling data.

6. The method according to claim 1, wherein the determining an on/off state of an optical fiber in the optical current transducer according to the detail coefficients corresponding to the plurality of current sampling data comprises:

   determining positive detail coefficients corresponding to the plurality of current sampling data as feature values, or determining absolute value of negative detail coefficients corresponding to the plurality of current sampling data as feature values; and
   determining the on/off state of the optical fiber in the optical current transducer based on a change law of the sampling order of the corresponding current sampling data according to the plurality of feature values.

7. The method according to claim 6, wherein the determining the on/off state of the optical fiber in the optical current transducer based on a change law of the sampling order of the corresponding current sampling data according to the plurality of feature values comprises:

   ordering the plurality of feature values according to the sampling order of the corresponding current sampling data from front to back;
   determining a first quantity of adjacent feature value pairs that a subsequent feature value is greater than or equal to a preceding feature value in the ordered feature values;
   determining a second quantity of adjacent feature value pairs that a subsequent feature value is less than a preceding feature value in the ordered feature values; and
   determining that an optical fiber break occurs in the optical current transducer in a case that a difference between the first quantity and the second quantity is greater than or equal to a quantity threshold.

8. The method according to claim 7, wherein the quantity threshold is in a range of [0.3N, 0.5N), where N is used for representing the quantity of current sampling data comprised in the plurality of current sampling data.

9. The method according to any one of claims 1 to 8, further comprising:
after determining that the optical fiber break occurs in the optical current transducer, setting an output value of the optical current transducer to an invalid state, and/or locking a relay protection apparatus that performs a protection action based on the output value of the optical current transducer.

10. An optical fiber break detection apparatus (800), comprising:

    an acquisition module (801), configured to acquire a plurality of current sampling data of a photodiode (14) in an optical current transducer;
    a transform module (802), configured to respectively perform wavelet transform on the plurality of current sampling data to obtain a detail coefficient corresponding to each of the current sampling data; and
    a detection module (803), configured to determine an on/off state of an optical fiber in the optical current transducer according to the detail coefficients corresponding to the plurality of current sampling data.

11. The apparatus according to claim 10, wherein
the acquisition module (801) is configured to acquire the plurality of current sampling data of the photodiode (14) continuously obtained by the optical current transducer; or select one current sampling datum at an interval of M current sampling data from the current sampling data of the photodiode (14) continuously obtained by the optical current transducer according to a sampling order of the current sampling data, so as to obtain the selected plurality of current sampling data, where M is an integer greater than or equal to 1.

12. The apparatus according to claim 10, wherein the plurality of current sampling data comprise N current sampling data, where N is an integer greater than 1, N is determined based on signal attenuation time and a sampling frequency corresponding to the plurality of current sampling data, the signal attenuation time is equal to time required for a current signal outputted by the photodiode (14) to attenuate to 0 after an optical fiber break occurs in the optical current transducer;

wherein $N = f_s \cdot \Delta t$, $f_s$ is used for representing the sampling frequency corresponding to the plurality of current sampling data, and $\Delta t$ is used for representing the signal attenuation time.

13. The apparatus according to claim 10, wherein
the transform module (802) is configured to respectively perform wavelet transform on the plurality of current sampling data through a Daubechies Wavelet function to obtain the detail coefficient corresponding to each of the current sampling data.

14. The apparatus according to claim 10, wherein the detection module (803) comprises:

a selection submodule (8031), configured to determine positive detail coefficients corresponding to the plurality of current sampling data as feature values, or determine absolute value of negative detail coefficients corresponding to the plurality of current sampling data as feature values; and
a determination submodule (8032), configured to determine the on/off state of the optical fiber in the optical current transducer based on a change law of the sampling order of the corresponding current sampling data according to the plurality of feature values.

15. The apparatus according to claim 14, wherein the determination submodule (8032) is configured to perform the following operations:

ordering the plurality of feature values according to the sampling order of the corresponding current sampling data from front to back;
determining a first quantity of adjacent feature value pairs that a subsequent feature value is greater than or equal to a preceding feature value in the ordered feature values;
determining a second quantity of adjacent feature value pairs that a subsequent feature value is less than a preceding feature value in the ordered feature values; and
determining that an optical fiber break occurs in the optical current transducer in a case that a difference between the first quantity and the second quantity is greater than or equal to a quantity threshold.

FIG. 1

200

```
┌─────────────────────────────────────┐
│                 201                  │
└─────────────────────────────────────┘
                   │
                   ▼
┌─────────────────────────────────────┐
│                 202                  │
└─────────────────────────────────────┘
                   │
                   ▼
┌─────────────────────────────────────┐
│                 203                  │
└─────────────────────────────────────┘
```

FIG. 2

FIG. 3

FIG. 4

500

```
┌─────────────────────────────────┐
│              501                │
└─────────────────────────────────┘
                 │
                 ▼
┌─────────────────────────────────┐
│              502                │
└─────────────────────────────────┘
                 │
                 ▼
┌─────────────────────────────────┐
│              503                │
└─────────────────────────────────┘
                 │
                 ▼
┌─────────────────────────────────┐
│              504                │
└─────────────────────────────────┘
```

FIG. 5

FIG. 6

FIG. 7

800

801 — 802 — 803

FIG. 8

FIG. 9

FIG. 10

FIG. 11

# EP 4 707 767 A1

**EUROPEAN SEARCH REPORT**

Europäisches
Patentamt
European
Patent Office
Office européen
des brevets

**Application Number**

EP 25 19 8045

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | CN 109 581 268 B (STATE GRID JILINSHENG ELECTRIC POWER SUPPLY CO ELECTRIC POWER RES INST) 11 June 2021 (2021-06-11) | 1,2,6,7, 9-11,14, 15 | INV. G01M11/00 G01R29/08 |
| A | * paragraphs [[0001]] - [[0083]] * ----- | 3-5,8, 12,13 | G01R31/08 G06F17/14 H04B10/079 |
| A | CN 215 871 418 U (INF & TELECOMMUNICATION CO STATE GRID QINGHAI ELECTRIC POWER CO ET AL.) 18 February 2022 (2022-02-18) * the whole document * ----- | 1-15 | |
| A | WO 2010/041583 A1 (TOKO ELECTRIC CORP [JP]; JAPAN AE POWER SYSTEMS CORP [JP] ET AL.) 15 April 2010 (2010-04-15) * the whole document * ----- | 1-15 | |
| A | CN 107 328 986 A (BEIJING AEROSPACE TIMES OPTICAL ELECTRONIC TECHNOLOGY CO LTD) 7 November 2017 (2017-11-07) * the whole document * ----- | 1-15 | |

TECHNICAL FIELDS
SEARCHED (IPC)

G01R
G01M
G06F
H04B

The present search report has been drawn up for all claims

| Place of search | Date of completion of the search | Examiner |
|---|---|---|
| Munich | 23 January 2026 | Kleiber, Michael |

EPO FORM 1503 03.82 (P04C01)

## ANNEX TO THE EUROPEAN SEARCH REPORT
## ON EUROPEAN PATENT APPLICATION NO.

EP 25 19 8045

This annex lists the patent family members relating to the patent documents cited in the above-mentioned European search report.
The members are as contained in the European Patent Office EDP file on
The European Patent Office is in no way liable for these particulars which are merely given for the purpose of information.

23-01-2026

| Patent document cited in search report | | Publication date | Patent family member(s) | | Publication date |
|---|---|---|---|---|---|
| CN 109581268 | B | 11-06-2021 | NONE | | |
| CN 215871418 | U | 18-02-2022 | NONE | | |
| WO 2010041583 | A1 | 15-04-2010 | JP | 2010091357 A | 22-04-2010 |
| | | | WO | 2010041583 A1 | 15-04-2010 |
| CN 107328986 | A | 07-11-2017 | NONE | | |

EPO FORM P0459

For more details about this annex : see Official Journal of the European Patent Office, No. 12/82